# EUROPÄISCHE PATENTANMELDUNG

(11) **EP 4 826 396 A1**
(43) Veröffentlichungstag der Anmeldung: **21.10.2026**
(21) Anmeldenummer: 26163845.6
(22) Anmeldetag: 11.03.2026
(51) Int. Cl.: G01R 29/08, G01R 23/17

(54) **ANALYSE EINES MIKROWELLENSIGNALS**

(30) Priorität: 11.04.2025 DE 102025114299
(71) Anmelder: Robert Bosch GmbH, 70442 Stuttgart (DE)
(72) Erfinder: Fuchs, Tino, 72076 Tuebingen (DE)

(57) **Zusammenfassung**

Die Erfindung betrifft eine Vorrichtung zum Analysieren eines Mikrowellensignals, umfassend:
ein Sensormedium, welches zumindest einen Stickstoff-Fehlstellen aufweisenden Diamantkristall aufweist,
eine Laserquelle zum Einstrahlen von Laserstrahlung in das Sensormedium, eine Magnetfelderzeugungseinrichtung, welche eingerichtet ist, jeweils ein unterschiedliches Magnetfeld über zumindest zwei Abschnitte des Sensormediums zu erzeugen, wobei das jeweilige Magnetfeld innerhalb des jeweiligen Abschnitts einen vorbestimmten Magnetfeldgradienten aufweist,
eine Einkopplungseinrichtung, welche eingerichtet ist, das zu analysierende Mikrowellensignal in das Sensormedium einzukoppeln, um ein dem zu analysierenden Mikrowellensignal entsprechendes Mikrowellenfeld in den zumindest zwei Abschnitten des Sensormediums zu erzeugen,
eine Ausleseeinrichtung, welche eingerichtet ist, eine von dem Mikrowellenfeld und dem jeweiligen Magnetfeld abhängige magnetische Resonanz der Stickstoff-Fehlstellen über die zumindest zwei Abschnitte auszulesen,
eine Auswerteeinheit, welche eingerichtet ist, basierend auf der ausgelesenen Resonanz das Mikrowellensignal zu analysieren.

Die Erfindung betrifft weiter ein Verfahren zum Kalibrieren der Vorrichtung und ein Verfahren zum Analysieren eines Mikrowellensignals, sowie ein Computerprogramm und ein maschinenlesbares Speichermedium.

## Beschreibung

Die Erfindung betrifft eine Vorrichtung und ein Verfahren zum Analysieren eines Mikrowellensignals, ein Verfahren zum Kalibrieren der Vorrichtung zum Analysieren eines Mikrowellensignals, ein Computerprogramm und ein maschinenlesbares Speichermedium.

### Stand der Technik

Die Patentanschrift US 10,571,498 B2 offenbart ein System zum Analysieren eines Mikrowellensignals.

### Offenbarung der Erfindung

Die der Erfindung zugrunde liegende Aufgabe ist darin zu sehen, ein Konzept zum effizienten Analysieren eines Mikrowellensignals bereitzustellen.

Die der Erfindung zugrunde liegende Aufgabe ist auch darin zu sehen, ein Konzept zum effizienten Kalibrieren einer Vorrichtung zum Analysieren eines Mikrowellensignals bereitzustellen.

Diese Aufgaben werden mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem ersten Aspekt wird eine Vorrichtung zum Analysieren eines Mikrowellensignals bereitgestellt, umfassend:
ein Sensormedium, welches zumindest einen Stickstoff-Fehlstellen aufweisenden Diamantkristall aufweist,
eine Laserquelle zum Einstrahlen von Laserstrahlung in das Sensormedium, eine Magnetfelderzeugungseinrichtung, welche eingerichtet ist, jeweils ein unterschiedliches Magnetfeld über zumindest zwei Abschnitte des Sensormediums zu erzeugen, wobei das jeweilige Magnetfeld innerhalb des jeweiligen Abschnitts einen vorbestimmten Magnetfeldgradienten aufweist,
eine Einkopplungseinrichtung, welche eingerichtet ist, das zu analysierende Mikrowellensignal in das Sensormedium einzukoppeln, um ein dem zu analysierenden Mikrowellensignal entsprechendes Mikrowellenfeld in den zumindest zwei Abschnitten des Sensormediums zu erzeugen,
eine Ausleseeinrichtung, welche eingerichtet ist, eine von dem Mikrowellenfeld und dem jeweiligen Magnetfeld abhängige magnetische Resonanz der Stickstoff-Fehlstellen über die zumindest zwei Abschnitte auszulesen,
eine Auswerteeinheit, welche eingerichtet ist, basierend auf der ausgelesenen Resonanz das Mikrowellensignal zu analysieren.

Nach einem zweiten Aspekt wird ein Verfahren zum Kalibrieren der Vorrichtung nach dem ersten Aspekt bereitgestellt, umfassend die folgenden Schritte: Einkoppeln von einem oder mehreren bekannten Referenzmikrowellensignalen in das Sensormedium durch die Einkopplungseinrichtung,
Auslesen der magnetischen Resonanz über die zumindest zwei Abschnitte durch die Ausleseeinrichtung unter Verwendung von durch die Laserquelle in das Sensormedium eingestrahlter Laserstrahlung und der durch die Magnetfelderzeugungseinrichtung erzeugten unterschiedlichen Magnetfelder, Kalibrieren der Vorrichtung basierend auf der ausgelesenen magnetischen Resonanz.

Nach einem dritten Aspekt wird ein Verfahren zum Analysieren eines Mikrowellensignals unter Verwendung der Vorrichtung nach dem ersten Aspekt bereitgestellt, umfassend die folgenden Schritte:
Einkoppeln von einem Mikrowellensignal in das Sensormedium durch die Einkopplungseinrichtung,
Auslesen der magnetischen Resonanz über die zumindest zwei Abschnitte durch die Ausleseeinrichtung unter Verwendung von durch die Laserquelle in das Sensormedium eingestrahlter Laserstrahlung und der durch die Magnetfelderzeugungseinrichtung erzeugten unterschiedlichen Magnetfelder, Analysieren des Mikrowellensignals basierend auf der ausgelesenen magnetischen Resonanz durch die Auswerteeinheit.

Nach einem vierten Aspekt wird ein Computerprogramm bereitgestellt, welches Befehle umfasst, die bei Ausführung des Computerprogramms durch die Vorrichtung nach dem ersten Aspekt diese veranlassen, ein Verfahren gemäß dem zweiten Aspekt und/oder gemäß dem dritten auszuführen.

Nach einem fünften Aspekt wird ein maschinenlesbares Speichermedium bereitgestellt, auf dem das Computerprogramm nach dem vierten Aspekt gespeichert ist.

Die Erfindung basiert auf der Erkenntnis und schließt diese mit ein, dass die obige Aufgabe dadurch gelöst wird, dass Teilbereiche bzw. Abschnitte des Sensormediums mit unterschiedlichen Magnetfeldern beaufschlagt werden. Dies bedeutet, dass innerhalb der zumindest zwei Abschnitte jeweils ein unterschiedliches Magnetfeld vorliegt. Es liegt somit eine kaskadierte Anordnung von unterschiedlichen Magnetfeldern über eine Fläche des Sensormediums, beispielsweise über eine Fläche eines Diamantkristalls, so dass unterschiedliche Teilbereiche bzw. Abschnitte unterschiedliche Magnetfeldgradienten und/oder Absolutstärken aufweisen. Somit kann z. B. innerhalb eines Abschnitts ein geringerer Magnetfeldgradient vorliegen, so dass hier eine hohe Auflösung der Vorrichtung erzielt werden kann, wobei in einem anderen Abschnitt ein entsprechend höherer Magnetfeldgradient vorliegen kann, so dass hier z. B. ein entsprechend großer Messbereich bewirkt werden kann.

Im Vergleich dazu ist bei dem in der vorstehend genannten US 10,571,498 B2 vorgesehenen Konzept vorgesehen, dass der Messbereich des Spektrometers durch den über die gesamte Fläche des Diamanten konstanten Magnetfeldgradienten beschränkt wird. Dadurch muss gemäß dem in der US 10,571,498 B2 beschriebenen Konzept stets ein Kompromiss zwischen großem Messbereich, d. h., starker Magnetfeldgradient und hoher Auflösung, d. h., geringer Magnetfeldgradient, eingegangen werden.

Gemäß dem hier beschriebenen Konzept ist hingegen vorgesehen, dass mehrere Abschnitte des Sensormediums, also insbesondere des Diamantkristalls, unterschiedliche Magnetfeldgradienten und/oder unterschiedliche Absolutstärken des Magnetfelds aufweisen. Somit muss im Gegensatz zu dem vorstehend beschriebenen Stand der Technik kein Kompromiss zwischen großem Messbereich und hoher Auflösung eingegangen werden, insofern es Abschnitte geben kann, welche einen hohen Messbereich aufweisen und es Abschnitte geben kann, welche eine hohe Auflösung aufweisen, was durch entsprechende Wahl des entsprechenden Magnetfelds bewirkt werden kann.

Somit wird also insbesondere der technische Vorteil bewirkt, dass ein Mikrowellensignal effizient analysiert werden kann.

Aufgrund des Kalibrierens der Vorrichtung gemäß dem hier beschriebenen Konzept wird insbesondere der technische Vorteil bewirkt, dass die Vorrichtung effizient kalibriert werden kann. Eine effiziente Kalibrierung ist besonders vorteilhaft für eine anschließende effiziente Analyse eines Mikrowellensignals.

Somit wird durch das Kalibrieren der Vorrichtung gemäß dem hier beschriebenen Konzept insbesondere der technische Vorteil bewirkt, dass ein Mikrowellensignal effizient analysiert werden kann.

Ein Analysieren eines Mikrowellensignals im Sinne der Erfindung umfasst z. B. ein Ermitteln einer Frequenz des Mikrowellensignals und/oder ein Ermitteln einer Intensität des Mikrowellensignals und/oder ein Ermitteln eines zeitlichen Verlaufs einer Frequenz des Mikrowellensignals und/oder ein Ermitteln eines zeitlichen Verlaufs einer Intensität des Mikrowellensignals.

Das hier beschriebene Konzept basiert auf dem Prinzip NV-Magnetometern. Hierbei steht "NV" für "Nitrogen Vacancy", also für Stickstoff-Fehlstellen. Bei dem NV-Magnetometer ist insbesondere vorgesehen, dass das zu messende Magnetfeld unbekannt ist, wohingegen eine Mikrowellenstrahlung zum Erzeugen eines Mikrowellenfelds innerhalb des Sensormediums des NV-Magnetometers bekannt ist. Vorliegend ist nun das Magnetfeld bekannt und das Mikrowellenfeld bzw. das Mikrowellensignal ist unbekannt.

Ein Sensormedium im Sinne der Beschreibung umfasst insbesondere einen oder mehrere Diamantkristalle, welche jeweils Stickstoff-Fehlstellen aufweisen.

Ausführungen, die im Zusammenhang mit einem Diamantkristall gemacht sind, gelten analog für mehrere Diamantkristalle und umgekehrt.

Die Funktionsweisen eines NV-Magnetometers und wie im Einzelnen die magnetische Resonanz der Stickstoff-Fehlstellen ausgelesen werden kann, sind als solche dem Fachmann bekannt. Rein beispielhaft werden nachfolgend beispielhafte Möglichkeiten betreffend bevorzugter Ausführungsformen beschrieben.

In einer Ausführungsform der Vorrichtung nach dem ersten Aspekt ist vorgesehen, dass die Einkopplungseinrichtung einen Mikrowellensplitter umfasst, welcher eingerichtet ist, das Mikrowellensignal in einer Anzahl der Abschnitte entsprechende Mikrowellensignale aufzusplitten, wobei die Einkopplungseinrichtung eingerichtet ist, die aufgesplitteten Mikrowellensignale jeweils in einen eigenen Abschnitt der zumindest zwei Abschnitte einzukoppeln.

Dadurch wird z. B. der technische Vorteil bewirkt, dass das Mikrowellensignal effizient in die entsprechenden Abschnitte eingekoppelt werden kann.

In einer Ausführungsform der Vorrichtung nach dem ersten Aspekt ist vorgesehen, dass die Einkopplungseinrichtung einen oder mehrere Mikrowellenverstärker zum Verstärken von Mikrowellensignalen aufweist.

Dadurch wird z. B. der technische Vorteil bewirkt, dass Mikrowellensignale effizient verstärkt werden können.

Z. B. ist vorgesehen, dass ein aufgesplittetes Mikrowellensignal durch einen Mikrowellenverstärker verstärkt wird.

Z. B. ist vorgesehen, dass ein noch aufzusplittendes Mikrowellensignal durch einen Mikrowellenverstärker verstärkt wird. Hier befindet sich dann z. B. ein Mikrowellenverstärker vor dem Mikrowellensplitter.

In einer Ausführungsform der Vorrichtung nach dem ersten Aspekt ist vorgesehen, dass zumindest ein Mikrowellenverstärker nach dem Mikrowellensplitter angeordnet und eingerichtet ist, ein entsprechend aufgesplittetes Mikrowellensignal vor Einkopplung in einen entsprechenden Abschnitt zu verstärken.

Dadurch wird z. B. der technische Vorteil bewirkt, dass ein entsprechend aufgesplittetes Mikrowellensignal effizient verstärkt werden kann.

Durch das Vorsehen eines oder mehrerer Mikrowellenverstärker wird allgemein insbesondere der technische Vorteil bewirkt, dass auch schwache Mikrowellensignale effizient analysiert werden können.

In einer Ausführungsform der Vorrichtung nach dem ersten Aspekt ist vorgesehen, dass die Einkopplungseinrichtung eine Mikrowellenantenne umfasst, welche eingerichtet ist, das Mikrowellensignal drahtlos zu empfangen, wobei die Einkopplungseinrichtung eingerichtet ist, das empfangene Mikrowellensignal in das Sensormedium einzukoppeln.

Dadurch wird z. B. der technische Vorteil bewirkt, dass ein Mikrowellensignal, welches drahtlos, also mittels Funk, übertragen wird, effizient analysiert werden kann.

In einer Ausführungsform der Vorrichtung nach dem ersten Aspekt ist vorgesehen, dass zumindest ein Mikrowellenverstärker nach der Mikrowellenantenne angeordnet ist, um das empfangene Mikrowellensignal zu verstärken.

Dadurch wird z. B. der technische Vorteil bewirkt, dass das empfangene Mikrowellensignal effizient verstärkt werden kann.

Z. B. ist vorgesehen, dass zumindest ein Mikrowellenverstärker zwischen Mikrowellenantenne und Mikrowellensplitter angeordnet ist.

Ein technischer Vorteil, nach dem Mikrowellensplitter zu verstärken, ist insbesondere darin zu sehen, dass bei einer eventuell ungleichmäßigen Aufteilung durch den Mikrowellensplitter, die Unterschiede in den Kanälen durch individuelle Verstärkungsfaktoren wieder ausgeglichen werden können.

In einer Ausführungsform der Vorrichtung nach dem ersten Aspekt ist vorgesehen, dass sich die unterschiedlichen Magnetfelder in ihrer Absolutstärke und/oder ihren Magnetfeldgradienten unterscheiden.

Dadurch wird z. B. der technische Vorteil bewirkt, dass sich die Magnetfelder besonders effizient voneinander unterscheiden.

In einer Ausführungsform der Vorrichtung nach dem ersten Aspekt ist vorgesehen, dass die Magnetfelderzeugungseinrichtung mehrere Permanentmagnete aufweist, wobei an gegenüberliegenden Seiten der zumindest zwei Abschnitte jeweils zumindest einer der Permanentmagnete angeordnet ist.

Dadurch wird z. B. der technische Vorteil bewirkt, dass die Magnetfelder effizient erzeugt werden können.

In einer Ausführung der Vorrichtung nach dem ersten Aspekt ist vorgesehen, dass die Magnetfelderzeugungseinrichtung einen oder mehrere Elektromagneten zum Erzeugen der unterschiedlichen Magnetfelder aufweist.

Dadurch wird z. B. der technische Vorteil bewirkt, dass die Magnetfelder effizient erzeugt werden können.

Zum Beispiel umfasst die Magnetfelderzeugungseinrichtung ein Joch aus Eisen, an welchem Spulenwicklungen angeordnet sind. Die gegenüberliegenden Enden des Jochs entsprechen zum Beispiel Orten eines jeweiligen Permanentmagnets.

In einer Ausführungsform der Vorrichtung nach dem ersten Aspekt ist vorgesehen, dass die Ausleseeinrichtung eingerichtet ist, die magnetische Resonanz mittels optischer Detektion von Fluoreszenzlicht und/oder mittels elektrischer Detektion von Photoelektronen auszulesen.

Dadurch wird z. B. der technische Vorteil bewirkt, dass die magnetische Resonanz effizient ausgelesen werden kann.

Eine optische Detektion von Fluoreszenzlicht umfasst z. B. eine ODMR-Messung. "ODMR" steht für "optically detected magnetic resonance", also für optisch detektierte magnetische Resonanz.

Eine elektrische Detektion von Photoelektronen kann auch als "PDMR" bezeichnet werden, wobei "PDMR" für "photoelectrically detected magnetic resonance" steht, also für "photoelektrisch detektierte magnetische Resonanz".

Es ist zum Beispiel vorgesehen, dass die PDMR-Messung ein pixelgenaues Auslesen umfasst. Das reihenweise respektive spaltenweise Auslesen kann analog zu einer CMOS-Kamera implementiert sein. Anstelle einer Photodiode (, kann auch als Fotodiode geschrieben werden,) kann bei PDMR eine lokale Interdigitalelektrode die Stromquelle sein, die zum Beispiel mit einem Kondensator ergänzt wird, welcher den elektrischen Strom in eine elektrische Spannung wandelt.

In einer Ausführungsform der Vorrichtung nach dem ersten Aspekt ist vorgesehen, dass die Ausleseeinrichtung eingerichtet ist, die magnetische Resonanz mittels optischer Detektion von Fluoreszenzlicht auszulesen, und wobei der Diamantkristall eine dielektrische Beschichtung als Longpass-Filter aufweist, um das Fluoreszenzlicht passieren zu lassen und elektromagnetische Strahlung mit einer kürzeren Wellenlänge als das Fluoreszenzlicht zurückzuhalten.

Dadurch wird z. B. der technische Vorteil bewirkt, dass ein Kontrast in der optischen Detektion effizient erhöht werden kann bei gleichzeitig kompakter Bauweise im Vergleich zu einer Verwendung eines diskreten optischen Longpass-Filters.

Z. B. ist vorgesehen, dass Fluoreszenzlicht größer oder größer gleich einer Wellenlänge von 580 nm passiert wird, wohingegen Elektromagnetische Strahlung mit einer Wellenlänge kleiner oder kleiner gleich 580 nm zurückgehalten wird. '

In einer Ausführungsform der Vorrichtung nach dem ersten Aspekt ist vorgesehen, dass die Ausleseeinrichtung eingerichtet ist, die magnetische Resonanz mittels optischer Detektion von Fluoreszenzlicht auszulesen, wobei die Ausleseeinrichtung einen mehrere Pixel aufweisenden Bildsensor aufweist, um das Fluoreszenzlicht pixelweise aufzunehmen, wobei die Auswerteeinheit eingerichtet ist, Pixeln des Bildsensors eine jeweilige Mikrowellenfrequenz zuzuordnen, wobei die Auswerteeinheit eingerichtet ist, basierend auf dem pixelweise ausgelesenen Fluoreszenzlicht eine Frequenz des Mikrowellensignals zu ermitteln.

Dadurch wird z. B. der technische Vorteil bewirkt, dass die Frequenz des Mikrowellensignals effizient ermittelt werden kann.

In einer Ausführungsform des Verfahrens nach dem zweiten Aspekt ist vorgesehen, dass zumindest eines des einen oder der mehreren Referenzmikrowellensignale ein monochromatisches Mikrowellensignal ist.

Dadurch wird z. B. der technische Vorteil bewirkt, dass ein besonders geeignetes Referenzmikrowellensignal verwendet wird.

In einer Ausführungsform des Verfahrens nach dem zweiten Aspekt ist vorgesehen, dass das Einkoppeln umfasst, dass mehrere bekannte Referenzmikrowellensignale mit unterschiedlichen Frequenzen eingekoppelt werden, um zu ermitteln, bei welchen Pixeln eine Intensität des Fluoreszenzlichts bei welcher Mikrowellenfrequenz abnimmt, wobei das Kalibrieren umfasst, dass Pixeln des Bildsensors jeweils eine Mikrowellenfrequenz basierend auf dem Ermittelten zugeordnet wird.

Dadurch wird z. B. der technische Vorteil bewirkt, dass das Pixel des Bildsensors effizient jeweils einer Mikrowellenfrequenz zugeordnet werden kann.

Ein Bildsensor im Sinne der Beschreibung ist z. B. ein CMOS-Sensor oder ist z. B. ein CCD-Sensor.

Der Schritt des Kalibrierens gemäß dem Verfahren nach dem zweiten Aspekt wird z. B. mittels der Auswerteeinheit durchgeführt. Die Auswerteeinheit ist z. B. eingerichtet, den Schritt des Kalibrierens durchzuführen.

Ausführungen, die im Zusammenhang mit der Vorrichtung nach dem ersten Aspekt gemacht sind, gelten analog für das Verfahren nach dem zweiten Aspekt und für das Verfahren nach dem dritten Aspekt und umgekehrt.

Vorrichtungsmerkmale ergeben sich analog aus entsprechenden Verfahrensmerkmalen des Verfahrens nach dem zweiten Aspekt und des Verfahrens nach dem dritten Aspekt und umgekehrt.

Die Vorrichtung nach dem ersten Aspekt ist z. B. programmtechnisch eingerichtet, das Computerprogramm auszuführen.

Die Vorrichtung nach dem ersten Aspekt ist z. B. eingerichtet, alle Schritte des Verfahrens nach dem zweiten Aspekt und/oder nach dem dritten Aspekt auszuführen.

Das Verfahren nach dem zweiten Aspekt ist z. B. ein computerimplementiertes Verfahren.

Das Verfahren nach dem dritten Aspekt ist z. B. ein computerimplementiertes Verfahren.

Die Formulierung "zumindest zwei Abschnitte" bedeutet also zwei oder mehr Abschnitte.

Abschnitte sind z. B. zumindest teilweise, insbesondere vollständig parallel zueinander festgelegt bzw. angeordnet.

Ein Abschnitt im Sinne der Beschreibung weist z. B. eine Streifenform auf.

"Stickstoff-Fehlstellen" kann durch "NV" abgekürzt werden.

Die Laserquelle ist z. B. eingerichtet, grüne Laserstrahlung, insbesondere Laserstrahlung in einer Wellenlänge von 532 nm, z. B. von 515 nm +/- 10 nm bei einer Halbleiter-Laserdiode, zu imitieren. Z. B. ist die Laserquelle eingerichtet, Laserimpulse zu imitieren. Die Laserquelle umfasst z. B. eine Halbleiter-Laserdiode, welche eingerichtet ist, Laserstrahlung mit einer Wellenlänge von 515 nm +/- 10 nm zu imitieren.

Die Ausleseeinrichtung umfasst z. B. einen oder mehrere Fotodetektoren. Ein Fotodetektor umfasst z. B. eine Fotodiode.

Die hier beschriebenen Ausführungsbeispiele und Ausführungsformen können in beliebiger Art und Weise miteinander kombiniert werden, auch wenn dies nicht explizit beschrieben ist.

Ein Abschnitt im Sinne der Beschreibung ist zum Beispiel direkt auf dem Diamantkristall vorgesehen, als zum Beispiel strukturierte metallische Beschichtung. Ein Abschnitt ist zum Beispiel als eine metallische Beschichtung auf dem Diamantkristall aufgebracht.

Die Erfindung wird im Folgenden anhand von bevorzugten Ausführungsbeispielen näher erläutert. Hierbei zeigen:
Fig. 1 eine Vorrichtung zum Analysieren eines Mikrowellensignals,
Fig. 2 ein Ablaufdiagramm eines Verfahrens zum Kalibrieren einer Vorrichtung zum Analysieren eines Mikrowellensignals,
Fig. 3 ein Ablaufdiagramm eines Verfahrens zum Analysieren eines Mikrowellensignals,
Fig. 4 ein maschinenlesbares Speichermedium,
Fig. 5 eine weitere Vorrichtung zum Analysieren eines Mikrowellensignals, und
Fig. 6 einen Graphen, welcher einen Magnetfeldverlauf von Magnetfeldern gemäß der weiteren Vorrichtung gemäß Fig. 5 zeigt.

Im Folgenden können für gleiche Merkmale gleiche Bezugszeichen verwendet werden.

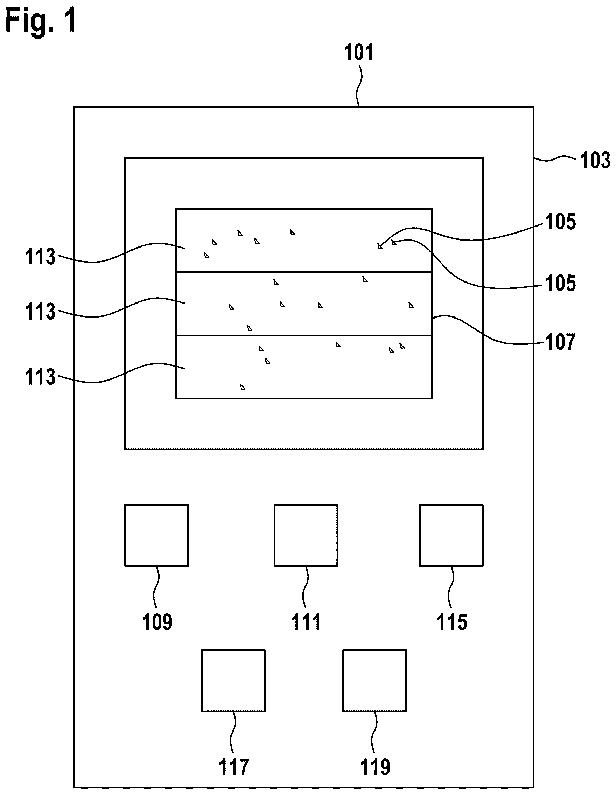

Fig. 1 zeigt eine Vorrichtung 101 zum Analysieren eines Mikrowellensignals, umfassend:
ein Sensormedium 103, welches zumindest einen Stickstoff-Fehlstellen 105 aufweisenden Diamantkristall 107 aufweist,
eine Laserquelle 109 zum Einstrahlen von Laserstrahlung in das Sensormedium 103,
eine Magnetfelderzeugungseinrichtung 111, welche eingerichtet ist, jeweils ein unterschiedliches Magnetfeld über zumindest zwei Abschnitte 113 des Sensormediums 103 zu erzeugen, wobei das jeweilige Magnetfeld innerhalb des jeweiligen Abschnitts einen vorbestimmten Magnetfeldgradienten aufweist,
eine Einkopplungseinrichtung 115, welche eingerichtet ist, das zu analysierende Mikrowellensignal in das Sensormedium 103 einzukoppeln, um ein dem zu analysierenden Mikrowellensignal entsprechendes Mikrowellenfeld in den zumindest zwei Abschnitten 113 des Sensormediums 103 zu erzeugen,
eine Ausleseeinrichtung 117, welche eingerichtet ist, eine von dem Mikrowellenfeld und dem jeweiligen Magnetfeld abhängige magnetische Resonanz der Stickstoff-Fehlstellen 105 über die zumindest zwei Abschnitte 113 auszulesen,
eine Auswerteeinheit 119, welche eingerichtet ist, basierend auf der ausgelesenen Resonanz das Mikrowellensignal zu analysieren.

Es wird angemerkt, dass die Fig. 1 die Vorrichtung lediglich symbolisch durch entsprechende Symbole zeigt.

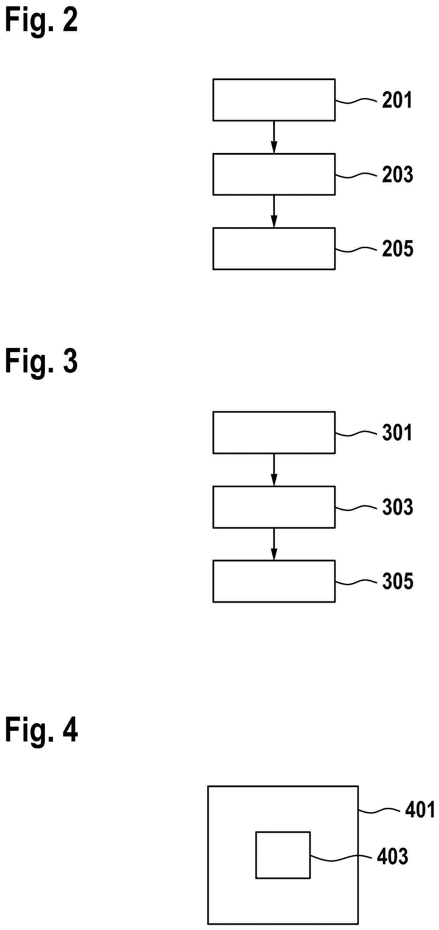

Fig. 2 zeigt ein Ablaufdiagramm eines Verfahrens zum Kalibrieren der Vorrichtung nach dem ersten Aspekt, umfassend die folgenden Schritte: Einkoppeln 201 von einem oder mehreren bekannten
Referenzmikrowellensignalen in das Sensormedium durch die Einkopplungseinrichtung,
Auslesen 203 der magnetischen Resonanz über die zumindest zwei Abschnitte durch die Ausleseeinrichtung unter Verwendung von durch die Laserquelle in das Sensormedium eingestrahlter Laserstrahlung und der durch die Magnetfelderzeugungseinrichtung erzeugten unterschiedlichen Magnetfelder, Kalibrieren 205 der Vorrichtung basierend auf der ausgelesenen magnetischen Resonanz.

Das Auslesen umfasst z. B. ein Auslesen der magnetischen Resonanz mittels optischer Detektion von Fluoreszenzlicht und/oder mittels elektrischer Detektion von Fotoelektroden.

Fig. 3 zeigt ein Ablaufdiagramm eines Verfahrens zum Analysieren eines Mikrowellensignals unter Verwendung der Vorrichtung nach dem ersten Aspekt, umfassend die folgenden Schritte:
Einkoppeln 301 von einem Mikrowellensignal in das Sensormedium durch die Einkopplungseinrichtung,
Auslesen 303 der magnetischen Resonanz über die zumindest zwei Abschnitte durch die Ausleseeinrichtung unter Verwendung von durch die Laserquelle in das Sensormedium eingestrahlter Laserstrahlung und der durch die Magnetfelderzeugungseinrichtung erzeugten unterschiedlichen Magnetfelder, Analysieren 305 des Mikrowellensignals basierend auf der ausgelesenen magnetischen Resonanz durch die Auswerteeinheit.

Das Auslesen der magnetischen Resonanz umfasst z. B. ein Auslesen mittels optischer Detektion von Fluoreszenzlicht und/oder mittels elektrischer Detektion von Fotoelektroden.

Fig. 4 zeigt ein maschinenlesbares Speichermedium 401, auf dem ein Computerprogramm 403 gespeichert ist. Das Computerprogramm 403 umfasst Befehle, die bei Ausführung des Computerprogramms 403 durch eine Vorrichtung nach dem ersten Aspekt diese veranlassen, ein Verfahren gemäß dem zweiten Aspekt und/oder gemäß dem dritten Aspekt auszuführen.

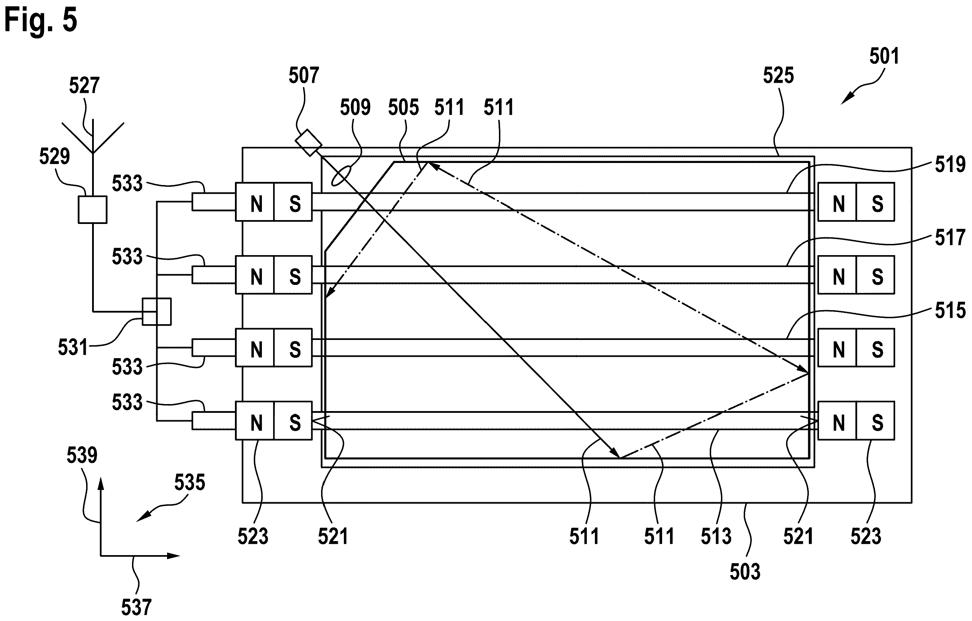

Fig. 5 zeigt eine weitere Vorrichtung 501 zum Analysieren eines Mikrowellensignals.

Die weitere Vorrichtung 501 umfasst ein Substrat 503, welches z. B. ein Mikrowellensubstrat ist.

Das Mikrowellensubstrat weist insbesondere eine auf einen Frequenzbereich der NV-Zentren angepasste dielektrische Konstante, um zum Beispiel geringe Reflexions- und Absorptionsverluste zu erzielen. Der Frequenzbereich der NV-Zentren umfasst respektive entspricht zum Beispiel das respektive dem geschlossene(n) Intervall von 1 GHz bis 100 GHz.

Auf dem Substrat 503 ist ein Diamantkristall 505 angeordnet, welcher Stickstoff-Fehlstellen aufweist.

Weiter umfasst die Vorrichtung 501 eine Laserdiode 507, welche Laserstrahlung mit z. B. einer Wellenlänge von 510 nm in den Diamantkristall 505 einstrahlen kann.

Der Diamantkristall 505 ist schematisch als Viereck aufweisend eine abgeschnittene Ecke links oben gezeichnet. Die abgeschnittene Ecke dient der Einkopplung der Laserstrahlung der Laserdiode 507 senkrecht zu einer Oberfläche des Diamantkristalls 505.

Über eine optionale Linse 509 kann die Lasterstrahlung effizient in den Diamantkristall 505 eingestrahlt werden. Ein Verlauf der Laserstrahlung ist beispielhaft durch Pfeile mit dem Bezugszeichen 511 gekennzeichnet.

Es sind beispielhaft vier Abschnitte im Diamantkristall 505 festgelegt bzw. definiert: Ein erster Abschnitt 513, ein zweiter Abschnitt 515, ein dritter Abschnitt 517 und ein vierter Abschnitt 519.

Die vier Abschnitte 513, 515, 517, 519 weisen jeweils eine Streifenform auf.

An gegenüberliegenden Enden 521 der Streifen 513, 515, 517, 519 ist jeweils ein Permanentmagnet 523 auf dem Substrat 503 angeordnet.

Zusätzlich oder anstelle zu dem Permanentmagneten können beispielsweise ein oder mehrere Elektromagneten vorgesehen sein.

Diese Permanentmagnete 523 erzeugen entlang der Streifen 513, 515, 517, 519 jeweils ein unterschiedliches Magnetfeld. Hierbei können sich die Magnetfelder in ihrem Magnetfeldgradienten und/oder in ihrer Absolutstärke unterscheiden.

Die Permanentmagnete 523 sind auf dem Substrat 503 angeordnet.

Oberhalb des Diamantkristalls 505, also somit auch oberhalb der definierten Abschnitte 513, 515, 517, 519 ist ein CMOS-Sensor 525 vorgesehen, um eine magnetische Resonanz durch Detektion von Fluoreszenzlicht optisch auszulesen. Der CMOS-Chip 525 ist Teil der Vorrichtung 501.

Weiter umfasst die Vorrichtung 501 eine Mikrowellenantenne 527 zum drahtlosen Empfangen von Mikrowellensignalen.

Hinter der Mikrowellenantenne 527 ist ein Mikrowellenverstärker 529 vorgesehen, welcher das empfangene Mikrowellensignal verstärkt.

Das verstärkte Mikrowellensignal wird durch einen Mikrowellensplitter 531 in vier Mikrowellensignale aufgesplittet, wobei die aufgesplitteten Mikrowellensignale jeweils in einen eigenen Abschnitt der vier Abschnitt 513, 515, 517, 519 eingekoppelt werden.

Z. B. sind Mikrowellenleitungen 533 vorgesehen, die innerhalb oder auf dem Substrat 503 verlaufen und zumindest teilweise jeweils unterhalb der vier Abschnitte 513, 515, 517, 519 verlaufen, so dass hierüber die aufgesplitteten Mikrowellensignale in die jeweiligen Abschnitte 513, 515, 517, 519 eingekoppelt werden können.

Zum Beispiel ist vorgesehen, die Abschnitte 513, 515, 517, 519 direkt auf dem Diamantkristall 505 vorzusehen, als zum Beispiel strukturierte metallische Beschichtung. Somit sind die Abschnitte 513, 515, 517, 519 zum Beispiel als metallische Beschichtung auf dem Diamantkristall 505 aufgebracht.

Zur besseren Orientierung ist ein zweidimensionales x, y-Koordinatensystem 535 eingezeichnet in Fig. 5. Das Bezugszeichen 537 kennzeichnet die x-Achse. Das Bezugszeichen 539 kennzeichnet die y-Achse.

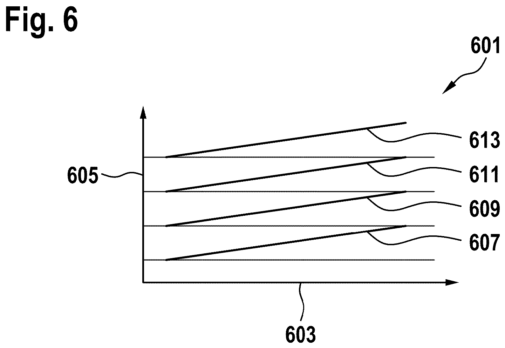

Fig. 6 zeigt einen Graphen 601, wobei eine Abszisse 603 des Graphen 601 der x-Achse 537 entspricht. Eine Ordinate 605 des Graphen 601 repräsentiert eine Magnetfeldstärke.

Im Graphen 601 sind vier Magnetfeldverläufe eingezeichnet: Ein erster Magnetfeldverlauf 607, ein zweiter Magnetverlauf 609, ein dritter Magnetfeldverlauf 611 und ein vierter Magnetfeldverlauf 613.

Der erste Magnetfeldverlauf 607 kennzeichnet einen Magnetfeldverlauf des Magnetfelds entlang des ersten Abschnitts 513. Der zweite Magnetfeldverlauf 609 kennzeichnet einen Magnetfeldverlauf des Magnetfelds entlang des zweiten Abschnitts 515. Der dritte Magnetfeldverlauf 611 kennzeichnet einen Magnetfeldverlauf des Magnetfelds entlang des dritten Abschnitts 517. Der vierte Magnetfeldverlauf 613 kennzeichnet einen Magnetfeldverlauf entlang des vierten Abschnitts 519.

Gemäß dem Graphen 601 der Fig. 6 ist die jeweilige Magnetfeldvariation bzw. der jeweilige Magnetfeldgradient der vier Magnetfelder gleich. Die Magnetfelder unterscheiden sich allerdings in ihrer Absolutstärke.

Zusammenfassend umfasst das hier beschriebene Konzept insbesondere eine kaskadierte Anordnung von Magnetfeldgradienten über eine Fläche eines Diamantkristalls, so dass unterschiedliche Teilbereiche bzw. Abschnitte des Diamantkristalls unterschiedliche Gradienten bzw. Magnetfeldverläufe haben. Damit lässt sich für jeden Teilbereich bzw. für jeden Abschnitt ein geringer Gradient und damit eine hohe Auflösung des Spektrometers erzielen, und durch ein paralleles Auslesen der Teilbereiche kann eine großer Messbereich realisiert werden.

Diese Teilbereiche mit unterschiedlichen Magnetfeldverlauf können insbesondere parallele Streifen sein, die jeweils den gleichen Gradienten haben, sich das absolute Magnetfeld aber von Streifen zu Streifen stetig erhöht. Erreicht wird dies zum Beispiel durch Verwendung von zwei Permanentmagneten an gegenüberliegenden Seiten eines Streifens des Diamantkristalls, wobei von Streifen zu Streifen die Remanenzfeldstärke zum Beispiel stetig zunimmt. Das kann z.B. so ausgestaltet sein, dass die Magnetfeldstärkeverläufe über die Streifen lückenlos ineinander übergehen, oder dass es im Magnetfeldverlauf zum Beispiel Lücken gibt. Letzteres ist insbesondere dann von Vorteil, wenn spezielle, festgelegte Frequenzbänder hochaufgelöst analysiert werden sollen. Auch die Verwendung stromführender Strukturen (Elektromagnete) zur Erzeugung der beschriebenen Magnetfeldkonfiguration ist insbesondere vorgesehen, ebenso wie eine beispielhafte Kombination aus Permanentmagneten und stromführenden Strukturen. Zum Beispiel wird das zu messende bzw. zu analysierende RF-Signal (RF steht für Radiofrequency, wobei hier das RF-Signal eine Frequenz im Mikrowellenbereich aufweist) unmittelbar vor dem Diamantkristall durch einen RF-Splitter beispielsweise zu gleichen Teilen in Einzelpfade aufgeteilt, und den oben beschriebenen Streifen zugeführt. Vor oder nach dem Splitter können insbesondere RF-Verstärker Verwendung finden. Zum Beispiel umfasst das Konzept ein Auslesen der magnetischen Resonanz der NV-Zentren im Diamantkristall per optischer Detektion (ODMR) und/oder per elektrischer Detektion der Photoelektronen (PDMR). Für den Fall der ODMR-Auslesung ist zum Beispiel ein dielektrisches Coating (Beschichtung) auf dem Diamantkristall vorgesehen, das bezüglich der Lichtwellenlänge als Longpass-Filter wirkt, d.h. das Fluoreszenzlicht im Wellenlängenbereich beispielsweise von über 580 nm passieren lässt, beispielsweise kürzere Wellenlängen dagegen zurückhält. Dadurch wird der Kontrast in der ODMR-Messung bei kompakter Bauweise erhöht, gegenüber einer Verwendung eines diskreten optischen Filters. Das hier beschriebene Konzept umfasst zum Beispiel ein Verfahren zum Kalibrieren der Vorrichtung, indem zum Beispiel definierte monochromatische RF-Signale bekannter Frequenz und Amplitude den Abschnitten, also den Streifen, des Diamantkristalls zugeführt werden, und damit zum Beispiel in der Kalibrationsmessung jedem Pixel des Bildsensors (ODMR) eine Frequenz zugeordnet wird, indem man zum Beispiel beobachtet, bei welchem Pixel bzw. welcher Spalte von Pixeln ein gemessener dem Fluoreszenzlicht entsprechender Photostrom zurückgeht, wenn die gewählte Frequenz angeboten bzw. zugeführt wird.

## Patentansprüche

1. Vorrichtung (101, 501) zum Analysieren eines Mikrowellensignals, umfassend:
ein Sensormedium (103), welches zumindest einen Stickstoff-Fehlstellen (105) aufweisenden Diamantkristall (107) aufweist,
eine Laserquelle (109) zum Einstrahlen von Laserstrahlung in das Sensormedium (103),
eine Magnetfelderzeugungseinrichtung (111), welche eingerichtet ist, jeweils ein unterschiedliches Magnetfeld über zumindest zwei Abschnitte (113) des Sensormediums zu erzeugen, wobei das jeweilige Magnetfeld innerhalb des jeweiligen Abschnitts einen vorbestimmten Magnetfeldgradienten aufweist,
eine Einkopplungseinrichtung (115), welche eingerichtet ist, das zu analysierende Mikrowellensignal in das Sensormedium (103) einzukoppeln, um ein dem zu analysierenden Mikrowellensignal entsprechendes Mikrowellenfeld in den zumindest zwei Abschnitten (113) des Sensormediums (103) zu erzeugen,
eine Ausleseeinrichtung (117), welche eingerichtet ist, eine von dem Mikrowellenfeld und dem jeweiligen Magnetfeld abhängige magnetische Resonanz der Stickstoff-Fehlstellen (105) über die zumindest zwei Abschnitte (113) auszulesen,
eine Auswerteeinheit (119), welche eingerichtet ist, basierend auf der ausgelesenen Resonanz das Mikrowellensignal zu analysieren.

2. Vorrichtung (101, 501) nach Anspruch 1, wobei die Einkopplungseinrichtung (115) einen Mikrowellensplitter (531) umfasst, welcher eingerichtet ist, das Mikrowellensignal in einer Anzahl der Abschnitte (113) entsprechende Mikrowellensignale aufzusplitten, wobei die Einkopplungseinrichtung (115) eingerichtet ist, die aufgesplitteten Mikrowellensignale jeweils in einen eigenen Abschnitt (113) der zumindest zwei Abschnitte (113) einzukoppeln.

3. Vorrichtung (101, 501) nach Anspruch 1 oder 2, wobei die Einkopplungseinrichtung (115) einen oder mehrere Mikrowellenverstärker (529) zum Verstärken von Mikrowellensignalen aufweist.

4. Vorrichtung (101, 501) nach Anspruch 2 und nach Anspruch 3, wobei zumindest ein Mikrowellenverstärker nach dem Mikrowellensplitter (531) angeordnet und eingerichtet ist, ein entsprechend aufgesplittetes Mikrowellensignal vor Einkopplung in einen entsprechenden Abschnitt (113) zu verstärken.

5. Vorrichtung nach einem der vorherigen Ansprüche, wobei die Einkopplungseinrichtung (115) eine Mikrowellenantenne (527) umfasst, welche eingerichtet ist, das Mikrowellensignal drahtlos zu empfangen, wobei die Einkopplungseinrichtung (115) eingerichtet ist, das empfangene Mikrowellensignal in das Sensormedium einzukoppeln.

6. Vorrichtung (101, 501) nach Anspruch 5, soweit rückbezogen auf Anspruch 3, wobei zumindest ein Mikrowellenverstärker (529) nach der Mikrowellenantenne (527) angeordnet ist, um das empfangene Mikrowellensignal zu verstärken.

7. Vorrichtung (101, 501) nach einem der vorherigen Ansprüche, wobei sich die unterschiedlichen Magnetfelder in ihrer Absolutstärke und/oder ihren Magnetfeldgradienten unterscheiden.

8. Vorrichtung (101, 501) nach einem der vorherigen Ansprüche, wobei die Magnetfelderzeugungseinrichtung (111) mehrere Permanentmagnete (523) aufweist, wobei an gegenüberliegenden Seiten der zumindest zwei Abschnitte (113) jeweils zumindest einer der Permanentmagnete (523) angeordnet ist.

9. Vorrichtung (101, 501) nach einem der vorherigen Ansprüche, wobei die Magnetfelderzeugungseinrichtung (111) einen oder mehrere Elektromagneten zum Erzeugen der unterschiedlichen Magnetfelder aufweist.

10. Vorrichtung (101, 501) nach einem der vorherigen Ansprüche, wobei die Ausleseeinrichtung (117) eingerichtet ist, die magnetische Resonanz mittels optischer Detektion von Fluoreszenzlicht und/oder mittels elektrischer Detektion von Photoelektronen auszulesen.

11. Vorrichtung (101, 501) nach Anspruch 10, wobei die Ausleseeinrichtung (117) eingerichtet ist, die magnetische Resonanz mittels optischer Detektion von Fluoreszenzlicht auszulesen, und wobei der Diamantkristall (107) eine dielektrische Beschichtung als Longpass-Filter aufweist, um das Fluoreszenzlicht passieren zu lassen und elektromagnetische Strahlung mit einer kürzeren Wellenlänge als das Fluoreszenzlicht zurückzuhalten.

12. Vorrichtung (101, 501) nach Anspruch 10 oder **11,** wobei die Ausleseeinrichtung (117) eingerichtet ist, die magnetische Resonanz mittels optischer Detektion von Fluoreszenzlicht auszulesen, wobei die Ausleseeinrichtung (117) einen mehrere Pixel aufweisenden Bildsensor aufweist, um das Fluoreszenzlicht pixelweise aufzunehmen, wobei die Auswerteeinheit (119) eingerichtet ist, Pixeln des Bildsensors eine jeweilige Mikrowellenfrequenz zuzuordnen, wobei die Auswerteeinheit (119) eingerichtet ist, basierend auf dem pixelweise ausgelesenen Fluoreszenzlicht eine Frequenz des Mikrowellensignals zu ermitteln.

13. Verfahren zum Kalibrieren der Vorrichtung nach einem der vorherigen Ansprüche, umfassend die folgenden Schritte:
Einkoppeln (201) von einem oder mehreren bekannten
Referenzmikrowellensignalen in das Sensormedium (103) durch die Einkopplungseinrichtung,
Auslesen (203) der magnetischen Resonanz über die zumindest zwei Abschnitte (113) durch die Ausleseeinrichtung (117) unter Verwendung von durch die Laserquelle (109) in das Sensormedium eingestrahlter Laserstrahlung und der durch die Magnetfelderzeugungseinrichtung (111) erzeugten unterschiedlichen Magnetfelder,
Kalibrieren (205) der Vorrichtung basierend auf der ausgelesenen magnetischen Resonanz.

14. Verfahren nach Anspruch 13, wobei zumindest eines des einen oder der mehreren Referenzmikrowellensignale ein monochromatisches Mikrowellensignal ist.

15. Verfahren nach Anspruch 13 oder 14 bezüglich der Vorrichtung soweit rückbezogen auf Anspruch 12, wobei das Einkoppeln umfasst, dass mehrere bekannte Referenzmikrowellensignale mit unterschiedlichen Frequenzen eingekoppelt werden, um zu ermitteln, bei welchen Pixeln eine Intensität des Fluoreszenzlichts bei welcher Mikrowellenfrequenz abnimmt, wobei das Kalibrieren umfasst, dass Pixeln des Bildsensors jeweils eine Mikrowellenfrequenz basierend auf dem Ermittelten zugeordnet wird.

16. Verfahren zum Analysieren eines Mikrowellensignals unter Verwendung der Vorrichtung nach einem der Ansprüche 1 bis 12, umfassend die folgenden Schritte:
Einkoppeln (301) von einem Mikrowellensignal in das Sensormedium (103) durch die Einkopplungseinrichtung (115),
Auslesen (303) der magnetischen Resonanz über die zumindest zwei Abschnitte (113) durch die Ausleseeinrichtung unter Verwendung von durch die Laserquelle (109) in das Sensormedium (103) eingestrahlter Laserstrahlung und der durch die Magnetfelderzeugungseinrichtung (111) erzeugten unterschiedlichen Magnetfelder,
Analysieren (305) des Mikrowellensignals basierend auf der ausgelesenen magnetischen Resonanz durch die Auswerteeinheit.

17. Computerprogramm (403), umfassend Befehle, die bei Ausführung des Computerprogramms (403) durch die Vorrichtung nach einem der Ansprüche 1 bis 12 diese veranlassen, ein Verfahren gemäß einem der Ansprüche 13 bis 16 auszuführen.

18. Maschinenlesbares Speichermedium (401), auf dem das Computerprogramm (403) nach Anspruch 17 gespeichert ist.
